# EUROPEAN PATENT APPLICATION

(11) **EP 4 823 289 A1**
(43) Date of publication of application: **14.10.2026**
(21) Application number: 24899969.0
(22) Date of filing: 06.12.2024
(51) Int. Cl.: H10H 20/855, H10H 20/00, H10F 39/12

(54) **STEP SEED-BASED MICROLENS AND PREPARATION METHOD THEREFOR**

(30) Priority: 08.12.2023 CN 202311680690
(71) Applicant: Innovision Technology (Suzhou) Co., Ltd, Suzhou, Jiangsu 215000 (CN)
(72) Inventor: YANG, Zhixiang, Suzhou, Jiangsu 215000 (CN); ZHU, Youliang, Suzhou, Jiangsu 215000 (CN); LIN, Xiao, Suzhou, Jiangsu 215000 (CN); WANG, Yazhou, Suzhou, Jiangsu 215000 (CN)
(74) Representative: Winter, Brandl - Partnerschaft mbB
(86) International application number: PCT/CN2024/137465
(87) International publication number: WO 2025/119336

(57) **Abstract**

The present invention relates to the field of semiconductor technologies, and discloses a microlens based on a step seed and a method for preparing the microlens. The microlens includes: a step seed structure, where the step seed structure includes a bottom plane layer and a top seed layer disposed on the bottom plane layer, and a length of the top seed layer is less than a length of the bottom plane layer, so that a step difference is formed between the top seed layer and the bottom plane layer; and a microlens housing layer disposed on an outer periphery of the step seed structure, where the microlens housing layer is of an inorganic transparent material, and the microlens housing layer protrudes toward a direction away from the bottom plane layer. Based on the technical solutions provided in this application, a shape that is of the microlens housing layer and that meets a requirement may be formed based on the designed step seed structure, so that the process is relatively simple and a yield is ensured.

## Description

This application claims priority to Chinese Patent Application No. 2023116806905, entitled "MICROLENS BASED ON STEP SEED AND METHOD FOR PREPARING MICROLENS" filed on December 08, 2023, which is incorporated herein by reference in its entirety.

### TECHNICAL FIELD

The present invention relates to the field of semiconductor technologies, and in particular, to a microlens based on a step seed and a method for preparing a microlens.

### BACKGROUND

As important optical elements, microlenses have attract significant attention due to features of a small volume, a light weight, and a high integration degree.

With development of the semiconductor industry, a series of solutions of preparing a microlens emerge sequentially. A conventional solution of preparing a microlens includes photoresist melting (Reflow), etching, printing, laser direct writing, electrowetting, and nano-imprinting. In the foregoing conventional solution of preparing a microlens, a process is relatively complex, thereby easily resulting in a yield problem. To simplify microlens preparation, the microlens may be prepared through deposition, and an overall deposition process is relatively simple.

However, a suitable shape of the microlens cannot be obtained if deposition, for example, chemical vapor deposition, is directly performed on an outer surface of a pixel unit. Therefore, it is urgent to provide a solution to how to construct a device to help obtain, during the deposition, a microlens meeting a shape requirement.

### SUMMARY

An objective of the present invention is to provide a microlens based on a step seed and a method for preparing a microlens. In this way, a microlens housing layer meeting a shape requirement can be formed based on a step seed structure, a process is relatively simple, and a yield is ensured.

To implement the foregoing invention objective, the present invention provides the following technical solutions:

According to an aspect, a microlens based on a step seed is provided, the microlens including:
a step seed structure, where the step seed structure includes a bottom plane layer and a top seed layer disposed on the bottom plane layer, and a length of the top seed layer is less than a length of the bottom plane layer, so that a step difference is formed between the top seed layer and the bottom plane layer; and
a microlens housing layer disposed on an outer periphery of the step seed structure, where the microlens housing layer is of an inorganic transparent material, and the microlens housing layer protrudes toward a direction away from the bottom plane layer.

In a possible implementation, the step seed structure is a pixel structure, and the pixel structure includes a pixel unit and a CMOS layer at a bottom of the pixel unit; and
at least one top layer in the pixel structure is used as the top seed layer, and at least one bottom layer in the pixel structure is used as the bottom plane layer.
In a possible implementation, the top seed layer includes a compound pixel layer in the pixel unit, and the bottom plane layer includes an ohmic layer and a bonding layer that are in the pixel unit, and the CMOS layer; or
the top seed layer includes a compound pixel layer an ohmic layer, and a bonding layer that are in the pixel unit, and the bottom plane layer includes the CMOS layer at the bottom of the pixel unit.

In a possible implementation, the step seed structure is a pixel structure having a filling layer, and the pixel structure having a tilling layer includes: a pixel unit, a CMOS layer at a bottom of the pixel unit, and a filling layer at a top of the pixel unit, and the filling layer is of a high-temperature-resistant organic material or an inorganic medium material; and
at least one top layer in the pixel structure having a filling layer is used as the top seed layer, and at least one bottom layer in the pixel structure having a filling layer is used as the bottom plane layer.

In a possible implementation, the top seed layer includes the filling layer in the pixel structure having a filling layer, and the bottom plane layer includes the pixel unit and the CMOS layer in the pixel structure having a filling layer.

In a possible implementation, a size of the filling layer gradually decreases in a direction away from the CMOS layer. In a possible implementation, the filling layer includes: a first filling layer at the top of the pixel unit, and a second filling layer on the first filling layer, where a length of the second filling layer is less than a length of the first filling layer, the top seed layer includes the second filling layer in the pixel structure having a filling layer, and the bottom plane layer includes the first filling layer the pixel unit that are in the pixel structure having a filling layer, and the CMOS layer.

In a possible implementation, a central axis of the filling layer is aligned with a central axis of the pixel unit.

In a possible implementation, the pixel unit further includes a passivation layer disposed on a side wall in a covering manner.

In a possible implementation, a common cathode layer is further disposed on a surface of the passivation layer and a top surface of the pixel unit in a covering manner.

In a possible implementation, the step difference falls within 0.5 µm to 10 µm.

In a possible implementation, a bottom diameter of the top seed layer falls within 0.5 µm to 10 µm.

In a possible implementation, a ratio of the step difference to the bottom diameter of the top seed layer falls within 0.5 to 3.

In a possible implementation, a height of the microlens housing layer is 0.5 times to 3 times a diameter of the microlens housing layer.

In a possible implementation, a diameter of the microlens housing layer is 0.8 times to 1 times a distance to a center of an adjacent pixel unit.

In a possible implementation, a bottom diameter of the top seed layer is 0.4 times to 0.8 times a distance to a center of an adjacent pixel unit.

In a possible implementation, a shape of the top seed layer includes:
a cylindrical shape, a frustal shape, a pyramidal shape, and a polygonal pyramidal shape.

In a possible implementation, a shape of the microlens housing layer includes a semispherical shape and a semi-rugby shape.

According to another aspect, a method for preparing a microlens is provided, the method being used for preparing the microlens according to the foregoing aspect, and including:
preparing a step seed structure, where the step seed structure includes a bottom plane layer and a top seed layer disposed on the bottom plane layer, and a length of the top seed layer is less than a length of the bottom plane layer, so that a step difference is formed between the top seed layer and the bottom plane layer; and
performing chemical vapor deposition by using the step difference, and forming a microlens housing layer on an outer periphery of the step seed structure through in-situ growth, where the microlens housing layer protrudes toward a direction away from the bottom plane layer, and the microlens housing layer is of an in organic transparent material.

In a possible implementation, the preparing a step seed structure includes:
performing patterned etching on a pixel unit; and
using a compound pixel layer in the patterned pixel unit as the top seed layer, and using an ohmic layer and a bonding layer that are in the patterned pixel unit and a CMOS layer at a bottom of the pixel unit as the bottom plane layer;
   or
using a compound pixel layer in the patterned pixel unit, an ohmic layer, and a bonding layer as the top seed layer, and using a CMOS layer at a bottom of the patterned pixel unit as the bottom plane layer.

In a possible implementation, the preparing a step seed structure includes:
performing patterned etching on a pixel unit; and
filling a top of the patterned pixel unit to form a filling layer, where the filling layer is of a high-temperature-resistant organic material or an inorganic medium material; and
performing patterned photoetching on the filling layer of the high-temperature-resistant organic material, or performing patterned etching on the filling layer of the inorganic medium material, so that a length of the patterned filling layer is less than a length of a top of the pixel unit, the filling layer is used as the top seed layer, and the pixel unit and a CMOS layer are used as the bottom plane layer;
   or
performing patterned photoetching on the filling layer of the high-temperature-resistant organic material, or performing patterned etching on the filling layer of the inorganic medium material, so that the patterned filling layer forms a first filling layer on a top of the pixel unit, a second filling layer on the first filling layer, a length of the second filling layer is less than a length of the first filling layer, the second filling layer is used as the top seed layer, and the first filling layer, the pixel unit, and a CMOS layer are used as the bottom plane layer.

In a possible implementation, after the performing patterned etching on a pixel unit, the method further includes:
passivating a side wall of the pixel unit to form a passivation layer; and
disposing a transparent conductive film on a surface of the passivation layer and a top surface of the pixel unit in a covering manner, to form a common cathode layer.

In a possible implementation, the performing chemical vapor deposition by using the step difference, and forming a microlens housing layer on an outer periphery of the step seed structure through in-situ growth includes:
controlling, by using a step seed related parameter including the step difference and an in-situ growth process parameter, a size and a shape of the microlens housing layer that is formed on the outer periphery of the step seed structure through in-situ growth and chemical vapor deposition.

Compared with the prior art, the present invention has the following beneficial effects:
During device construction, the step seed structure is formed. The step seed structure includes the bottom plane layer and the top seed layer disposed on the bottom plane layer, and the length of the top seed layer is less than the length of the bottom plane layer, so that the step difference is formed between the top seed layer and the bottom plane layer. In this case, the microlens housing layer is formed on the step seed structure. The microlens housing layer may naturally protrude toward the direction away from the bottom plane layer based on settings of a step seed, to obtain a required microlens.

Further, the microlens housing layer formed through in-situ growth is of an inorganic transparent material that can more easily overcome a high-temperature test and a mechanical deformation test compared with an organic material.

Further, the size and a profile of the microlens are also controlled by means of a design of the step seed structure, and changes such as separately preparing an imprinting template are not required, thereby facilitating mass production operations.

### BRIEF DESCRIPTION OF THE DRAWINGS

FIG. 1 is a schematic diagram of a structure of a microlens according to an embodiment of this application;
FIG. 2 is a schematic diagram of a structure of a microlens according to an embodiment of this application;
FIG. 3 is a schematic diagram of a structure of a microlens according to an embodiment of this application;
FIG. 4 is a schematic diagram of a structure of a microlens according to an embodiment of this application;
FIG. 5 is a schematic diagram of a structure of a pixel unit according to an embodiment of this application;
FIG. 6 is a schematic diagram of a structure of a pixel unit according to an embodiment of this application;
FIG. 7 is a schematic diagram of a structure of a filled pixel unit according to an embodiment of this application;
FIG. 8 is a schematic diagram of a structure of a filled pixel unit according to an embodiment of this application;
FIG. 9 is a schematic diagram of a structure of a filled pixel unit according to an embodiment of this application;
FIG. 10 is a schematic diagram of a structure of a pixel unit according to an embodiment of this application;
FIG. 11 is a method flowchart of a method for preparing a microlens according to an embodiment of this application;
FIG. 12 is a schematic diagram of a light-emitting parameter of a structure without a microlens according to an embodiment of this application; and
FIG. 13 is a schematic diagram of a light-emitting parameter of a structure with a microlens according to an embodiment of this application.

### DETAILED DESCRIPTION

To make objectives, technical solutions, and advantages of embodiments of the present invention clearer, the technical solutions in the embodiments of the present invention are to be clearly and completely described below with reference to the accompanying drawings in the embodiments of the present invention. Apparently, the embodiments to be described are a part rather than all of the embodiments of the present invention. Based on the embodiments of the present invention, all other embodiments obtained by a person of ordinary skill in the art without creative efforts fall within the protection scope of the present invention.

It needs to be understood that, in descriptions of the present invention, a direction or positional relationship indicated by terms such as "perpendicular", "up", "down", "top", "side", "internal", and "external" is a direction or positional relationship based on in the accompanying drawings, and is merely intended for ease or brevity of description of the present invention, but does not necessarily mean or imply that the indicated apparatus or element is provided in the specified direction or constructed or operated in the specified direction. Therefore, such terms are not to be understood as a limitation on the present invention. In addition, terms "first" and "second" are used only for the purpose of description, and shall not be construed as indicating or implying relative importance or implying a quantity of indicated technical features. Therefore, features defined with "first" and "second" may explicitly or implicitly include one or more of the features. In the description of the present invention, unless otherwise specified, "a plurality of" means at least two.

In the descriptions of the present invention, it should be noted that, unless otherwise explicitly specified or defined, the terms such as "install", "connect", and "connection" are to be understood in a broad sense. For example, the connection may be a fixed connection, a detachable connection, or an integral connection; or the connection may be a mechanical connection or an electrical connection; or the connection may be a direct connection, an indirect connection through an intermediary, or internal communication between two elements. For a person of ordinary skill in the art, specific meanings of the foregoing terms in the present invention may be understood based on specific situations.

A conventional solution of preparing a microlens has disadvantages in many aspects, for example:
(1) A microlens is prepared by using a photoresist melting solution, where the lens in this solution is of an organic structure, and a material has poor temperature resistance and poor mechanical deformation performance resistance, for example, Patent CN117008226A.
(2) A microlens is prepared by using an imprinting solution. The lens in this solution is also of an organic structure. In addition to poor material temperature resistance and poor mechanical performance, an imprinting template needs to be additionally prepared. A process is relatively complex, and a yield problem such as adhesion easily occurs during demolding after imprinting, such as CN1977189A and CN114913558A.
(3) A microlens is prepared by using an etching solution. A microlens profile is prepared by using a photoresist melting solution, a pattern is transferred through etching, and the microlens profile is transferred to quartz. The solution has a relatively high requirement on a process and is relatively complex, and a melting and etching structure is prone to lens deformation, leading to a yield problem, for example, Patent CN115343788A.

To avoid the foregoing problem, in the embodiments of this application, a technical solution of forming a microlens housing layer by using a step seed structure as a guide and by using a deposited inorganic oxide or oxynitride is provided. The microlens housing layer may be designed based on the step seed structure, to form a shape conforming to a requirement.

First, a specific structure of a microlens provided in this application is described.

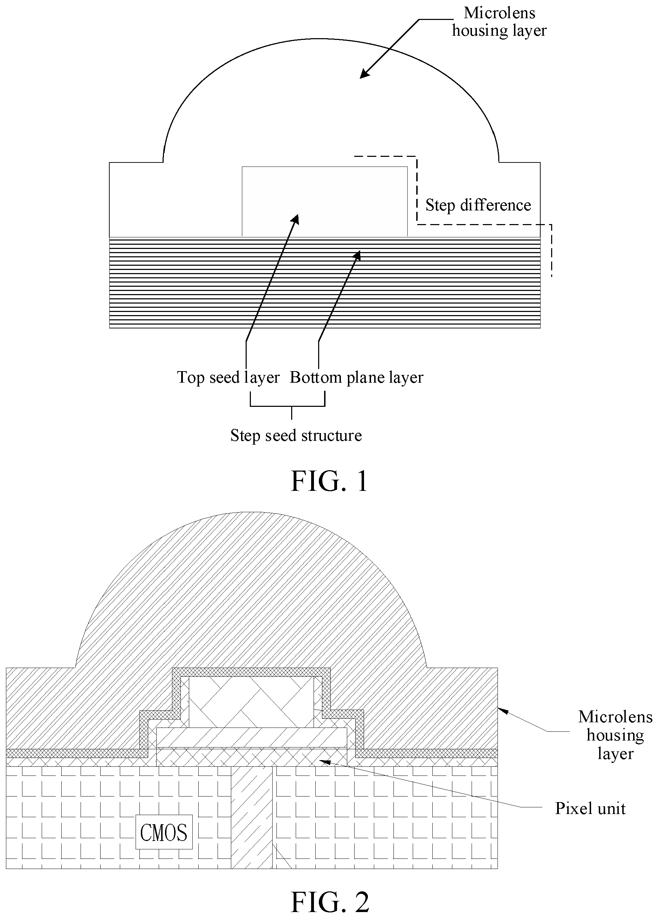

An embodiment of this application provides a microlens based on a step seed (a microlens for short below). As shown in FIG. 1, the microlens includes:
a step seed structure, where the step seed structure includes a bottom plane layer and a top seed layer disposed on the bottom plane layer, and a length of the top seed layer is less than a length of the bottom plane layer, so that a step difference is formed between the top seed layer and the bottom plane layer; and a microlens housing layer disposed on an outer periphery of the step seed structure, where the microlens housing layer is of an inorganic transparent material, and the microlens housing layer protrudes toward a direction away from the bottom plane layer.

In this embodiment of this application, the microlens is formed by using the step seed structure. The step seed structure refers to a seed structure in a step pattern, and may be divided into the bottom plane layer and the top seed layer disposed on the bottom plane layer. Because the length of the top seed layer is less than the length of the bottom plane layer, the two layers form the step pattern with the step difference.

Based on the design of the step seed structure, chemical vapor deposition (CVD) is performed by using the top seed layer as a center, to form the microlens housing layer of the inorganic transparent material through in-situ growth. Due to existence of the step difference, a thickness of a housing layer that grows in situ from the top seed layer to a top is obviously greater than a thickness of a housing layer that grows in situ to two sides, so that the microlens housing layer naturally protrudes toward the direction away from the bottom plane layer, to obtain a required protrusive microlens housing layer.

Further, a ratio of the step difference to a bottom diameter of the top seed layer falls within 0.5 to 3. Under a design in which the ratio of the step difference to the bottom diameter of the top seed layer falls within 0.5 to 3, a protrusion of the microlens housing layer accordingly adapts to the limitation, to form a required protrusion shape.

The microlens housing layer may specifically be of an inorganic transparent medium layer material such as a silicon oxide, a silicon nitride, or an aluminium oxide. A thickness of the microlens prepared based on the step seed may be equal to a thickness of the top seed layer plus a thickness of the microlens housing layer.

It may be understood that because the top seed layer and the bottom plane layer may have different lengths at different heights, the length of the top seed layer being less than the length of the bottom plane layer may specifically refer to that a longest length of the top seed layer is less than a shortest length of the bottom plane layer.

The step difference falls within 0.5 µm to 10 µm. Within the range, a microlens housing layer having a height meeting a requirement may be suitably formed.

The bottom diameter of the top seed layer falls within 0.5 µm to 10 µm. Within the range, a microlens housing layer having a surface width meeting a requirement may be suitably formed.

Further, the bottom diameter of the top seed layer is 0.4 times to 0.8 times a distance to a center of an adjacent pixel unit, so that a matched microlens housing layer is obtained based on the top seed layer within such a size range. The microlens housing layer may be in a one-to-one correspondence to each pixel unit, and may also cover the pixel unit, thereby achieving a relatively good optical collimation effect.

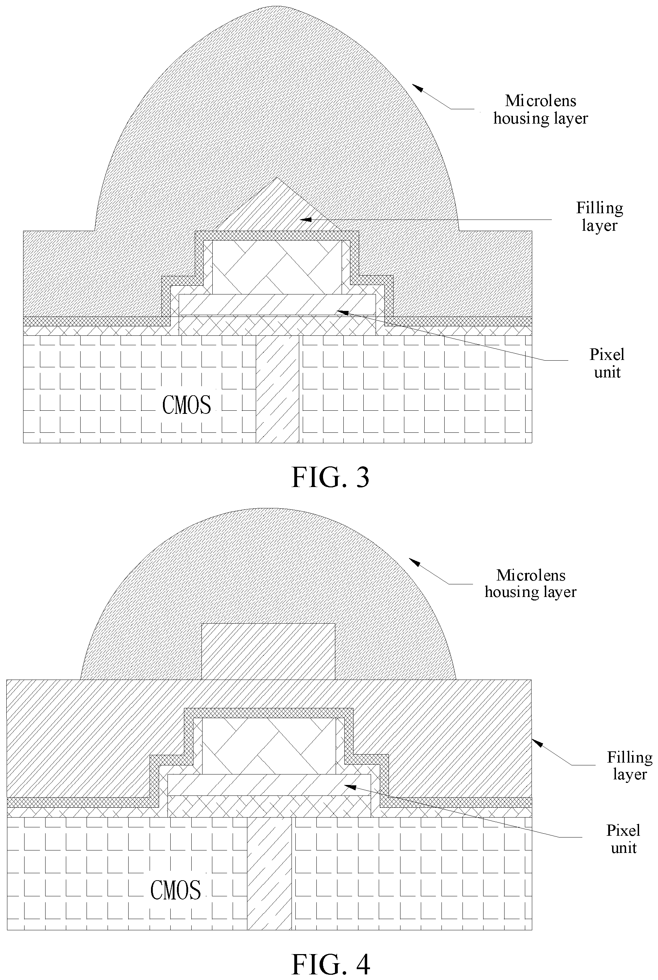

The step seed structure may be formed by an individual pixel unit. As shown in FIG. 2, a microlens is prepared by forming the step seed structure by using a pixel structure including the pixel unit and a CMOS layer; or may be formed by a pixel structure filled with a filling layer. The filling layer may use a high-temperature-resistant organic material (≥ 200°C) such as SU8, silicon, or polyimide, or may use an inorganic medium material such as a silicon oxide. As shown in FIG. 3 or FIG. 4, a microlens is prepared by using a step seed structure formed by using the pixel structure filled with a filling layer.

In a possible implementation, the step seed structure is a pixel structure; and at least one top layer in the pixel structure is used as the top seed layer, and at least one bottom layer in the pixel structure is used as the bottom plane layer.

In this implementation, the step seed structure is formed by using an individual pixel structure, at least one top layer in the pixel structure is used as the top seed layer, and at least one bottom layer in the pixel structure is used as the bottom plane layer.

Further, based on the foregoing implementation, the top seed layer includes a compound pixel layer in the pixel unit, and the bottom plane layer includes an ohmic layer and a bonding layer that are in the pixel unit, and a CMOS layer at a bottom of the pixel unit; or the top seed layer includes a compound pixel layer, an ohmic layer, and a bonding layer that are in the pixel unit, and the bottom plane layer includes the CMOS layer at a bottom of the pixel unit.

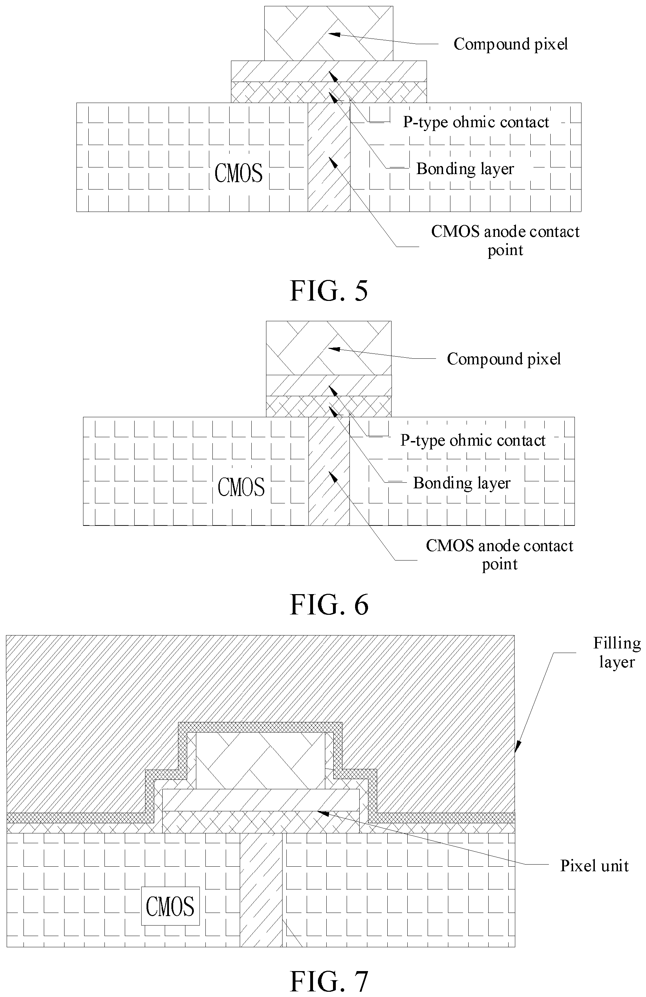

That is, as shown in FIG. 5 and FIG. 6, the pixel unit includes: the compound pixel layer, the ohmic layer, and the bonding layer, and the pixel unit and the CMOS layer form the pixel structure. When the step seed structure is formed by using the individual pixel structure, a possible manner is as follows: As shown in FIG. 5, patterned etching is performed on the compound pixel layer in the pixel unit to serve as the top seed layer, and another layer in the pixel unit, that is, the ohmic layer, the bonding layer, and the bottom CMOS layer, is used as the bottom plane layer. Another possible manner is as follows: As shown in FIG. 6, patterned etching is performed on the compound pixel layer and the bonding layer in the pixel unit to form an entity, where the entity is used as the top seed layer, and another layer, that is, the CMOS layer, in the pixel structure is used as the bottom plane layer. It may be understood that, forming the step seed structure in this manner is relatively simple to implement.

In a possible implementation, the step seed structure is a pixel structure that has a filling layer and that is formed by a pixel unit, a filling layer filled on a top of the pixel unit, and a CMOS layer at the bottom of the pixel unit, and the filling layer is of a high-temperature-resistant organic material or an inorganic medium material; and at least one top layer in the pixel structure having a filling layer is used as the top seed layer, and at least one bottom layer in the pixel structure having a filling layer is used as the bottom plane layer.

In this implementation, as shown in FIG. 7, a top of a prepared pixel unit is filled with a high-temperature-resistant organic material or an inorganic medium material (for example, a silicon oxide), to form a pixel structure having a filling layer. The pixel structure having a filling layer has a step seed structure. At least one top layer in the pixel structure having a filling layer is used as the top seed layer, and at least one bottom layer in the pixel structure having a filling layer is used as the bottom plane layer.

Further, based on the foregoing implementation, the top seed layer includes the filling layer, and the bottom plane layer includes the pixel unit and the CMOS layer. In addition, a size of the filling layer may gradually decrease in a direction away from the CMOS layer, so that the corresponding microlens housing layer can have a protrusive shape. In addition, a central axis of the filling layer is aligned with a central axis of the pixel unit, so that a central axis of a subsequent microlens housing layer can be aligned with a central axis of a final pixel unit, to better implement a function of the microlens housing layer.

Further, the filling layer includes: a first filling layer on the top of the pixel unit, and a second filling layer on the first filling layer. A length of the second filling layer is less than a length of the first filling layer. The top seed layer includes the second filling layer in the filled pixel unit. The bottom plane layer includes the first filling layer, the pixel unit, and the CMOS layer that are in the filled pixel unit. In addition, a central axis of the first filling layer, a central axis of the second filling layer, and the central axis of the pixel unit are aligned, so that the central axis of the subsequent microlens housing layer can be aligned with the central axis of the final pixel unit, to better implement a function of the microlens housing layer.

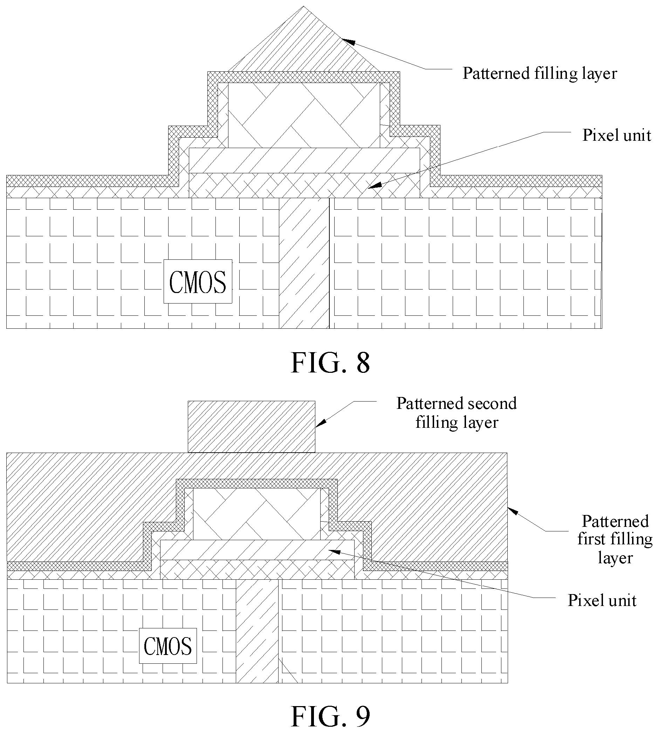

That is, when the step seed structure is formed by using the pixel unit filled with a filling layer, a possible manner is as follows: As shown in FIG. 8, the filling layer is patterned, so that a length of the filling layer is less than a length of the top of the pixel unit, the filling layer is used as the top seed layer, and the pixel unit and the CMOS layer are used as the bottom plane layer. A microlens prepared by using the step seed structure corresponding to FIG. 8 is shown in FIG. 3. Another possible manner is as follows: As shown in FIG. 9, the filling layer is patterned to form a first filling layer and a second filling layer from bottom to top. A length of the second filling layer is less than a length of the first filling layer. The second filling layer is used as the top seed layer, and the remaining first filling layer, pixel unit, and CMOS layer are used as the bottom plane layer. The microlens prepared by using the step seed structure corresponding to FIG. 9 is shown in FIG. 4. It may be understood that, forming the step seed structure in this manner does not need to be limited by a shape of the pixel unit, and related structural parameters such as a shape, a diameter, and a height of the top seed layer may be controlled more flexibly, to obtain a required microlens housing layer based on the top seed layer.

Further, a center distance between two adjacent pixel units is defined as a pitch. In a design in which the filling layer is used as the top seed layer, a diameter of a projection of the top seed layer on the CMOS layer may be controlled to 0.4 times pitch to 0.8 times pitch, and a height is controlled to 0.5 times to 3 times a diameter of the top seed layer, so that a diameter of a final microlens housing layer is controlled to 0.8 times to 1 times pitch, and a height of the microlens housing layer is 0.5 times to 3 times the diameter of the microlens housing layer, thereby obtaining a required microlens housing layer.

It may be understood that, as shown in the foregoing two implementations, the step seed structure required in this application may be performed by using a common step difference solution. For example, patterned photoetching may be directly performed on an organic material, for example, a high-temperature-resistant organic material such as SU8, silicon, or a polyimide, or formation may be performed by etching an inorganic material. For example, a displayed compound pixel layer and a subsequent growing inorganic medium material need to be formed. The step seed solution for preparing a microlens does not involve complex processes such as melting, imprinting, and laser direct writing, nor does it require a traditional procedure of etching after masking and melting a microlens profile. Extremely high consistency between melting and etching does not need to be required, the process is simple, and a yield is high. In addition, compared with a seed structure of another shape, for example, a semispherical seed structure, for preparing a microlens by using the step seed solution, semispherical etching does not need to be controlled by melting a mask layer to a semispherical shape or by debugging an etching process. Therefore, control precision is higher, the process is simple, and feasibility is higher.

In a possible implementation, the pixel unit further includes a passivation layer disposed on a side wall in a covering manner.

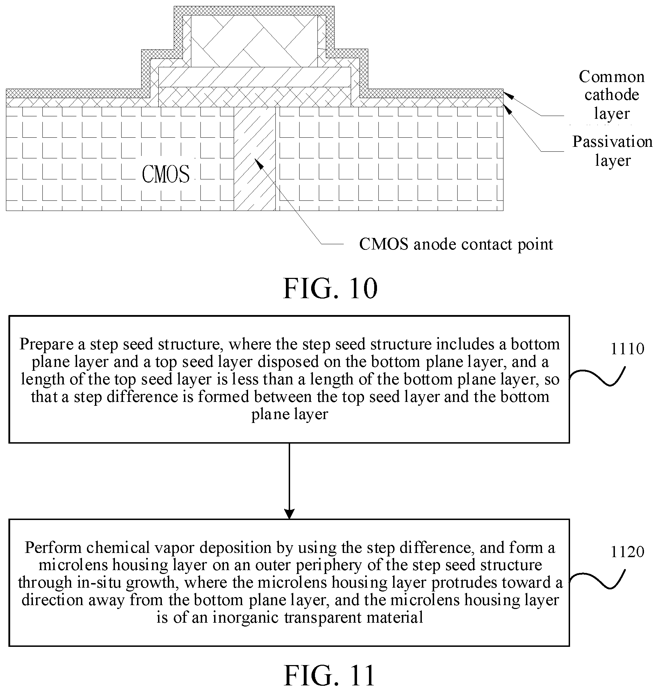

In this implementation, as shown in FIG. 10, the passivation layer is disposed on a surface of the side wall of the pixel unit in a covering manner, to perform passive protection on the pixel unit. The passivation layer may be a single layer or a stacked layer of a medium layer such as an aluminum oxide, a silicon nitride, or a silicon oxide.

In a possible implementation, a common cathode layer is further disposed on a surface of the passivation layer and a top surface of the pixel unit in a covering manner.

In this implementation, as shown in FIG. 10, the common cathode layer is further disposed on the surface of the passivation layer and the top surface of the pixel unit in a covering manner, to complete preparation of a common cathode of the pixel unit. The common cathode layer may use a transparent conductive thin film. The transparent conductive thin film may be one or a combination of a plurality of an indium tin oxide (ITO) thin film, an antimony doped zine oxide (AZO) thin film, an antimony doped tin oxide (ATO) thin film, and a fluorine doped tin oxide (FTO) thin film. Alternatively, the transparent conductive thin film may be formed by depositing a thin metal (such as Al, Au, or Ag) on a surface of ITO and then annealing the thin metal to form metal-doped ITO, to enhance a current transport capability of the common cathode layer.

In a possible implementation, a shape of the top seed layer includes: a cylindrical shape, a frustal shape, a pyramidal shape, and a polygonal pyramidal shape. That is, the shape of the top seed layer in the step seed structure may be set to a cylindrical shape, a frustal shape, a pyramidal shape, a polygonal pyramidal shape (such as a hexagon or an octagon), or the like as required in a patterning process.

In a possible implementation, a shape of the microlens housing layer includes: a semispherical shape and a semi-rugby shape. That is, the microlens housing layer formed through in-situ growth may be set to a semispherical microlens, or may be set to a semi-rugby-shaped microlens housing layer as required.

To sum up, based on the microlens provided in this embodiment of this application, during device construction, the step seed structure is formed. The step seed structure includes the bottom plane layer and the top seed layer disposed on the bottom plane layer, and the length of the top seed layer is less than the length of the bottom plane layer, so that the step difference is formed between the top seed layer and the bottom plane layer. In this case, the microlens housing layer is formed on the step seed structure. The microlens housing layer may naturally protrude toward the direction away from the bottom plane layer based on settings of a step seed, to obtain a required microlens.

Further, the microlens housing layer formed through in-situ growth is of an inorganic transparent material that can more easily overcome a high-temperature test and a mechanical deformation test compared with an organic material.

The following describes a method for preparing a microlens corresponding to the microlens in the foregoing embodiment.

An embodiment of this application further provides a method for preparing a microlens. The method is used to prepare the microlens in the foregoing embodiment. As shown in FIG. 11, the method may include the following steps:

Step 1110: Prepare a step seed structure, where the step seed structure includes a bottom plane layer and a top seed layer disposed on the bottom plane layer, and a length of the top seed layer is less than a length of the bottom plane layer, so that a step difference is formed between the top seed layer and the bottom plane layer.

In this step, the step seed structure having the step difference is prepared. The step seed structure includes the bottom plane layer and the top seed layer, and the length of the top seed layer is prepared to be less than the length of the bottom plane layer, to form the step difference.

In a possible implementation, step 1110 includes:
(1) Perform patterned etching on a pixel unit.

Specifically, for a pixel unit structure shown in FIG. 5 and FIG. 6, patterned etching is performed on a compound pixel layer, an ohmic layer, and a bonding layer from top to bottom.

(2.1) The compound pixel layer in the patterned pixel unit is used as the top seed layer, and the ohmic layer and the bonding layer that are in the patterned pixel unit and the CMOS layer at a bottom of the pixel unit are used as the bottom plane layer.

As shown in FIG. 5, under a design in which a length of the compound pixel layer on which patterned etching is performed is less than lengths of the ohmic layer, the bonding layer, and the CMOS layer, the compound pixel layer in the patterned pixel unit is used as the top seed layer, and the ohmic layer and the bonding layer that are in the patterned pixel unit and the CMOS layer at a bottom of the pixel unit are used as the bottom plane layer, to prepare and form the step seed structure.

(2.2) The compound pixel layer, the ohmic layer, and the bonding layer that are in the patterned pixel unit are used as the top seed layer, and the CMOS layer at a bottom of the patterned pixel unit is used as the bottom plane layer.

As shown in FIG. 6, under a design in which a length of an entity formed by performing patterned etching on the compound pixel layer, the ohmic layer, and the bonding layer is less than a length of the CMOS layer, the compound pixel layer, the ohmic layer, and the bonding layer in the patterned pixel unit is used as the top seed layer, and the CMOS layer is used as the bottom plane layer, to prepare and form the step seed structure.

In a possible implementation, step 1110 includes:
(1) Perform patterned etching on the pixel unit.

Specifically, for the pixel unit structure shown in FIG. 5 and FIG. 6, patterned etching is performed on the compound pixel layer, the ohmic layer, the bonding layer, and the CMOS layer from top to bottom.

(2) Fill a top of the patterned pixel unit to form a filling layer, where the filling layer is of a high-temperature-resistant organic material or an inorganic medium material.

Specifically, the pixel unit is filled by using a high-temperature-resistant organic material or an inorganic medium material (such as a silicon oxide) that is specifically filled at the top of the pixel unit.

(3.1) Perform patterned photoetching on the filling layer of the high-temperature-resistant organic material, or perform patterned etching on the filling layer of the inorganic medium material, so that a length of the patterned filling layer is less than a length of the top of the pixel unit, the filling layer is used as the top seed layer, and the pixel unit and the CMOS layer are used as the bottom plane layer.

As shown in FIG. 7 and FIG. 8, for the filled pixel unit including the pixel unit and the filling layer, if the filling layer uses a high-temperature-resistant organic material, the filling layer is patterned through photoetching. If the filling layer uses an inorganic medium material, the filling layer is patterned through etching, so that a length of the patterned filling layer is less than a length of the top of the pixel unit. The filling layer is used as the top seed layer, and the pixel unit and the CMOS layer are used as the bottom plane layer, thereby preparing and forming the step seed structure.

(3.2) Perform patterned photoetching on the filling layer of the high-temperature-resistant organic material, or perform patterned etching on the filling layer of the inorganic medium material, so that the patterned filling layer forms a first filling layer on the top of the pixel unit, and a second filling layer on the first filling layer, a length of the second filling layer is less than a length of the first filling layer, the second filling layer is used as the top seed layer, and the first filling layer, the pixel unit, and the CMOS layer are used as the bottom plane layer.

As shown in FIG. 7 and FIG. 9, for the filled pixel unit including the pixel unit and the filling layer, if the filling layer uses the high-temperature-resistant organic material, the filling layer is patterned through photoetching. If the filling layer uses the inorganic medium material, the filling layer is patterned through etching, so that the patterned filling layer is divided into the first filling layer and the second filling layer, and a length of the second filling layer is less than a length of the first filling layer. The second filling layer is used as the top seed layer, and the first filling layer, the pixel unit, and the CMOS layer are used as the bottom plane layer, thereby preparing and forming the step seed structure.

In a possible implementation, after the performing patterned etching on a pixel unit in the foregoing step, the method further includes the following steps: passivating a side wall of the pixel unit to form a passivation layer; and disposing a transparent conductive film on a surface of the passivation layer and a top surface of the pixel unit in a covering manner, to form a common cathode layer.

In this step, after patterned etching on the pixel unit is completed, passivation on a side wall of a compound pixel and current spreading of a common cathode are further introduced to complete N-type ohmic contact and preparation of the common cathode.

Step 1120: Perform chemical vapor deposition by using the step difference, and form a microlens housing layer on an outer periphery of the step seed structure through in-situ growth, where the microlens housing layer protrudes toward a direction away from the bottom plane layer, and the microlens housing layer is of an inorganic transparent material.

In this step, by using the step seed structure that is prepared in advance as a guide, a deposited inorganic transparent material naturally grows into a microlens structure by using an inorganic silicon oxide or a nitrogen oxide that has a feature of mobility and that is prepared by using a phosphate glass (PSG) process or a boron-phosphorus silicate glass (BPSG) process or by using a deposition source such as tetraethoxysilane (TEOS), and a triethyl phosphate (TEPO).

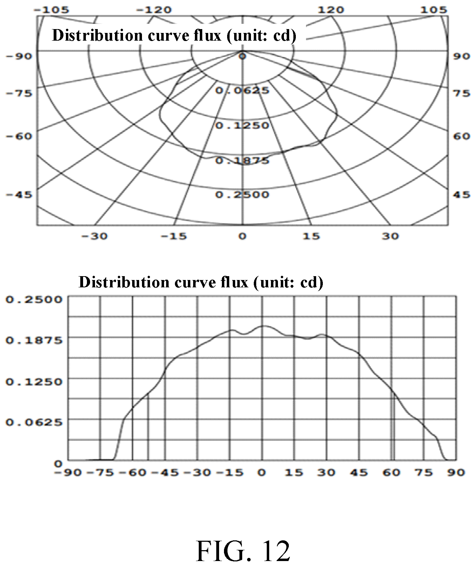

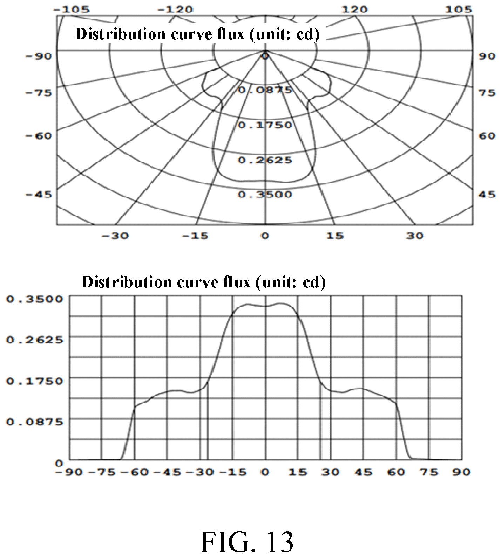

In an embodiment, a micro-LED micro display chip is used as an example. After the microlens grows in situ, luminous intensity is increased by 80%, and a luminous angle converges from 110° (as shown in FIG. 12, without a microlens) to 51° (as shown in FIG. 13, with a microlens growing in situ).

In a possible implementation, step 920 includes: controlling, by using a step seed related parameter including the step difference and an in-situ growth process parameter, a size and a shape of the microlens housing layer that is formed on the outer periphery of the step seed structure through in-situ growth and chemical vapor deposition.

In this step, the size and the shape of the formed microlens housing layer are related to the step seed related parameter and the in-situ growth process parameter. The step seed related parameter refers to a parameter related to the step seed structure, such as the step difference and a size (such as a height, a lower bottom length, and an upper top length ) of the top seed layer. The in-situ growth process parameter refers to a parameter used in a process of in-situ growth through chemical vapor deposition, for example, whether to use a high-temperature annealing process.

In an embodiment, a semi-rugby-shaped microlens may be prepared by preparing a step seed structure whose top seed layer is conical. If required, the semi-rugby-shaped microlens continues to flow after high-temperature annealing is subsequently performed, and may reflow to a semispherical shape. A semi-rugby-shaped microlens may be obtained by preparing a top seed layer whose lower bottom is 2 µm, upper top is 1.6 µm, and height is 1.5 µm and then growing 1 µm of PSG through CVD. Then, a semispherical microlens may be obtained by performing annealing by using a 500°C to 800°C nitrogen environment for two hours.

It may be understood that, after the microlens housing layer is formed based on this solution, the microlens housing layer may further be processed, to precisely control the shape of the microlens housing layer. This is not limited in this application.

In conclusion, based on the method for preparing a microlens provided in this embodiment of this application, the step seed structure may be prepared based on a conventional step difference solution, and chemical vapor deposition may be directly performed on the step seed structure, to form the microlens through in-situ growth. In an overall process, complex special melting and special etching technologies do not need to be performed, thereby reducing process difficulty and complexity, implementing good compatibility of a semiconductor process, and ensuring low costs and a mass production yield.

Further, the microlens housing layer formed through in-situ growth is of an inorganic transparent material that can more easily overcome a high-temperature test and a mechanical deformation test compared with an organic material.

Further, in a process of preparing the microlens, a size and a profile of the microlens may be flexibly controlled by means of the design of the step seed structure and the in-situ growth process such as high-temperature annealing. Changes such as separately preparing an imprinting template are not required, thereby facilitating mass production operations.

Any combination of all the foregoing optional technical solutions may be used to form optional embodiments of the present invention, that is, a plurality of embodiments may be combined randomly, to obtain requirements for dealing with different application scenarios, all of which fall within the protection scope of this application, and details are not described herein again.

It should be noted that the foregoing descriptions are merely preferred embodiments of the present invention, and are not intended to limit the present invention. Any modification, equivalent replacement, and improvement made without departing from the spirit and principle of the present invention shall fall within the protection scope of the present invention.

## Claims

1. A microlens based on a step seed, **characterized in that**, the microlens comprising:
a step seed structure, wherein the step seed structure comprises a bottom plane layer and a top seed layer disposed on the bottom plane layer, and a length of the top seed layer is less than a length of the bottom plane layer, so that a step difference is formed between the top seed layer and the bottom plane layer; and
a microlens housing layer disposed on an outer periphery of the step seed structure, wherein the microlens housing layer is of an inorganic transparent material, and the microlens housing layer protrudes toward a direction away from the bottom plane layer.

2. The microlens according to claim 1, **characterized in that**, the step seed structure is a pixel structure, and the pixel structure comprises a pixel unit and a CMOS layer at a bottom of the pixel unit; and
at least one top layer in the pixel structure is used as the top seed layer, and at least one bottom layer in the pixel structure is used as the bottom plane layer.

3. The microlens according to claim 2, **characterized in that**,
the top seed layer comprises a compound pixel layer in the pixel unit, and the bottom plane layer comprises an ohmic layer and a bonding layer that are in the pixel unit, and the CMOS layer; or
the top seed layer comprises a compound pixel layer, an ohmic layer, and a bonding layer that are in the pixel unit, and the bottom plane layer comprises the CMOS layer at the bottom of the pixel unit.

4. The microlens according to claim 1, **characterized in that**, the step seed structure is a pixel structure having a filling layer, and the pixel structure having a filling layer comprises: a pixel unit, a CMOS layer at a bottom of the pixel unit, and a filling layer at a top of the pixel unit, and the filling layer is of a high-temperature-resistant organic material or an inorganic medium material; and
at least one top layer in the pixel structure having a filling layer is used as the top seed layer, and at least one bottom layer in the pixel structure having a filling layer is used as the bottom plane layer.

5. The microlens according to claim 4, **characterized in that**,
the top seed layer comprises the filling layer in the pixel structure having a filling layer, and the bottom plane layer comprises the pixel unit and the CMOS layer in the pixel structure having a filling layer.

6. The microlens according to claim 5, **characterized in that**,
a size of the filling layer gradually decreases in a direction away from the CMOS layer.

7. The microlens according to claim 4, **characterized in that**, the filling layer comprises:
a first filling layer at the top of the pixel unit, and a second filling layer on the first filling layer, wherein a length of the second filling layer is less than a length of the first filling layer, the top seed layer comprises the second filling layer in the pixel structure having a filling layer, and the bottom plane layer comprises the first filling layer, the pixel unit, and the CMOS layer that are in the pixel structure having a filling layer.

8. The microlens according to claim 4, **characterized in that**,
a central axis of the filling layer is aligned with a central axis of the pixel unit.

9. The microlens according to claim 2 or 4, **characterized in that**,
the pixel unit further comprises a passivation layer disposed on a side wall in a covering manner.

10. The microlens according to claim 8, **characterized in that**,
a common cathode layer is further disposed on a surface of the passivation layer and a top surface of the pixel unit in a covering manner.

11. The microlens according to claim 1, **characterized in that**,
the step difference falls within 0.5 µm to 10 µm.

12. The microlens according to claim 1, **characterized in that**,
a bottom diameter of the top seed layer falls within 0.5 µm to 10 µm.

13. The microlens according to claim 1, **characterized in that**,
a bottom diameter of the top seed layer is 0.4 times to 0.8 times a distance to a center of an adjacent pixel unit.

14. The microlens according to claim 1, **characterized in that**,
a ratio of the step difference to the bottom diameter of the top seed layer falls within 0.5 to 3.

15. The microlens according to claim 1, **characterized in that**,
a height of the microlens housing layer is 0.5 times to 3 times a diameter of the microlens housing layer.

16. The microlens according to claim 1, **characterized in that**,
a diameter of the microlens housing layer is 0.8 times to 1 times a distance to a center of an adjacent pixel unit.

17. The microlens according to claim 1, **characterized in that**, a shape of the top seed layer comprises:
a cylindrical shape, a frustal shape, a pyramidal shape, and a polygonal pyramidal shape.

18. The microlens according to claim 1, **characterized in that**, a shape of the microlens housing layer comprises a semispherical shape and a semi-rugby shape.

19. A method for preparing a microlens, **characterized in that**, the method is used for preparing the microlens according to any one of claims 1 to 18, and the method comprises:
preparing a step seed structure, wherein the step seed structure comprises a bottom plane layer and a top seed layer disposed on the bottom plane layer, and a length of the top seed layer is less than a length of the bottom plane layer, so that a step difference is formed between the top seed layer and the bottom plane layer; and
performing chemical vapor deposition by using the step difference, and forming a microlens housing layer on an outer periphery of the step seed structure through in-situ growth, wherein the microlens housing layer protrudes toward a direction away from the bottom plane layer, and the microlens housing layer is of an in organic transparent material.

20. The method according to claim 19, **characterized in that**, the preparing a step seed structure comprises:
performing patterned etching on a pixel unit; and
using a compound pixel layer in the patterned pixel unit as the top seed layer, and using an ohmic layer and a bonding layer that are in the patterned pixel unit and a CMOS layer at a bottom of the pixel unit as the bottom plane layer; or
using a compound pixel layer, an ohmic layer, and a bonding layer that are in the patterned pixel unit as the top seed layer, and using a CMOS layer at a bottom of the patterned pixel unit as the bottom plane layer.

21. The method according to claim 19, **characterized in that**, the preparing a step seed structure comprises:
performing patterned etching on a pixel unit; and
filling a top of the patterned pixel unit to form a filling layer, wherein the filling layer is of a high-temperature-resistant organic material or an inorganic medium material; and
performing patterned photoetching on the filling layer of the high-temperature-resistant organic material, or performing patterned etching on the filling layer of the inorganic medium material, so that a length of the patterned filling layer is less than a length of a top of the pixel unit, the filling layer is used as the top seed layer, and the pixel unit and a CMOS layer are used as the bottom plane layer; or
performing patterned photoetching on the filling layer of the high-temperature-resistant organic material, or performing patterned etching on the filling layer of the inorganic medium material, so that the patterned filling layer forms a first filling layer on a top of the pixel unit, a second filling layer on the first filling layer, a length of the second filling layer is less than a length of the first filling layer, the second filling layer is used as the top seed layer, and the first filling layer, the pixel unit, and a CMOS layer are used as the bottom plane layer.

22. The method according to claim 20 or 21, **characterized in that**, after the performing patterned etching on a pixel unit, the method further comprises:
passivating a side wall of the pixel unit to form a passivation layer; and
disposing a transparent conductive film on a surface of the passivation layer and a top surface of the pixel unit in a covering manner, to form a common cathode layer.

23. The method according to claim 19, **characterized in that**, the performing chemical vapor deposition by using the step difference, and forming a microlens housing layer on an outer periphery of the step seed structure through in-situ growth comprises:
controlling, by using a step seed related parameter comprising the step difference and an in-situ growth process parameter, a size and a shape of the microlens housing layer that is formed on the outer periphery of the step seed structure through in-situ growth and chemical vapor deposition.
